## Europäisches Patentamt
## European Patent Office
## Office européen des brevets

(19)

(11) Publication number: **0 013 314**
**A2**

(12) **EUROPEAN PATENT APPLICATION**

(21) Application number: **79104471.2**

(22) Date of filing: **13.11.79**

(51) Int. Cl.³: **H 01 L 23/36**

(30) Priority: **17.11.78 JP 140963/78**

(43) Date of publication of application:
**23.07.80 Bulletin 80/15**

(84) Designated Contracting States:
**DE FR GB**

(71) Applicant: **Hitachi, Ltd.**
**5-1, Marunouchi 1-chome**
**Chiyoda-ku Tokyo 100(JP)**

(72) Inventor: **Kooriyama, Tsutomu**
**1365, Tahiko**
**Katsuta Ibaraki(JP)**

(72) Inventor: **Yamaya, Mitsumasa**
**3207-3, Godai Naka**
**Naka-gun Ibaraki(JP)**

(72) Inventor: **Kaminaga, Kaji**
**174-39, Suwama Tokai-mura**
**Naka-gun Ibaraki(JP)**

(74) Representative: **Beetz, sen., Richard, Dipl.-Ing.**
**Patentanwälte Dipl.-Ing. R. Beetz Sen. Dipl.-Ing. K.**
**Lamprecht;-Dr. Ing. R. Beetz Jr. et al,**
**Rechtsanwalt Dipl.-Phys. Dr. Jur. U. Heidrich Dr.-Ing. W.**
**Timpe; Dipl.-Ing. J. Siegfried Dipl.-Chem. Dr.Rer.Nat.W.**
**Schmitt-Fumian Steinsdorfstrasse 10**
**D-8000 München 22(DE)**

(54) **Semiconductor device comprising a cooling body.**

(57) Disclosed is a semiconductor device (10) having the following construction. A power transistor chip (100) is secured to a thermally conductive, electrically insulative plate (300) via a first solder layer (240). The electrically insulative plate (300) is in turn secured to a heat sink (160) made of copper via a second solder layer (260). Slits (362) having a U-shaped cross-section are formed on both faces of the electrically insulative plate (300) so as to lead to the outside a gas which is entrapped into the first and second solder layers (240, 260) when they are formed. Further, a thermally conductive layer (340) is formed on both faces of the electrically insulative plate (300) at portions other than the portions of the slits (362).

FIG. 1

FIG. 3A

TITLE OF THE INVENTION:

"SEMICONDUCTOR DEVICE"

## BACKGROUND OF THE INVENTION

This invention relates to a semiconductor device and more specifically to a semiconductor device having the construction wherein the heat generated from a semiconductor wafer is transferred to a heat sink via an electrically insulative member.

A semiconductor wafer such as a power transistor used for power amplification or for large current control generates high heat because the current to be controlled is great. To remove this heat, the semiconductor wafer of this kind is generally secured to a heat sink via a thermally conductive, electrically insulative member (such as disclosed in U.S. Patent No. 3,025,437). Securement is generally effected by soldering. When a solder is used, however, it is difficult to form solder layers between the semiconductor wafer and the electrically insulative member and between the electrically insulative member and the heat sink without gaps so that gaps not filled up with the solder (generally referred to as "voids") are formed inevitably. The voids thus formed in the solder layers lower the heat transfer. In consequence, the heat transfer from the semiconductor wafer to the heat sink becomes insufficient and the semiconductor wafer tends to be broken disadvantageously.

On the other hand, there has been known a silver solder as a solder material having less occurrence of voids. It is therefore possible in principle to use the silver solder in place of the solder but the problem here is that the brazing temperature of the silver solder is as high as about $800^{\circ}$C. If the semiconductor wafer is silver-soldered to the electrically insulative member and the electrically insulative member is silver-soldered to the heat sink at this temperature, there occur again such problems, due to the difference of the thermal expansion coefficients of these materials, as curving of the electrically insulative member, occurrence of irregular cracks, and so forth. Curving of the insulative member results in lowering of the heat transfer and cracks result in dielectric breakdown.

## SUMMARY OF THE INVENTION

It is therefore an object of the present invention to provide a semiconductor device having high reliability.

It is another object of the present invention to provide a semiconductor device having a reduced occurrence rate of voids.

- 3 -                                              0013314

It is still another object of the present invention to provide a semiconductor device which is able to prevent u_lectric breakdown.

These objects of the invention can be accomplished by fitting a semiconductor wafer to a heat sink via a thermally conductive, electrically insulative member equipped with slits as claimed in claim 1 or 6 or 11 or 16.

In accordance with the present invention, voids that are formed at the time of soldering are reduced because a gas forming such voids is dissipated to the outside through slits disposed on the electrically insulative member. Consequently, as diffusion of the heat generated from the semiconductor wafer is carried out efficiently, it is possible to prevent breakdown of the semiconductor wafer and to improve its reliability.

## BRIEF DESCRIPTION OF THE DRAWINGS

Figure 1 is a longitudinal sectional view of the semiconductor device in accordance with the present invention;

Figures 2A and 2B are plan views, each showing the construction of the insulative member to be fitted to the semiconductor device of the present invention;

Figures 3A, 3B and 3C are sectional views, each taken along line III - III of Figure 2A; and

Figure 4 is a diagram showing the comparative data between the total void rate of the semiconductor device in accordance with the present invention and that of the conventional semiconductor device.

## DETAILED DESCRIPTION OF THE PREFERRED EMBODIMENT

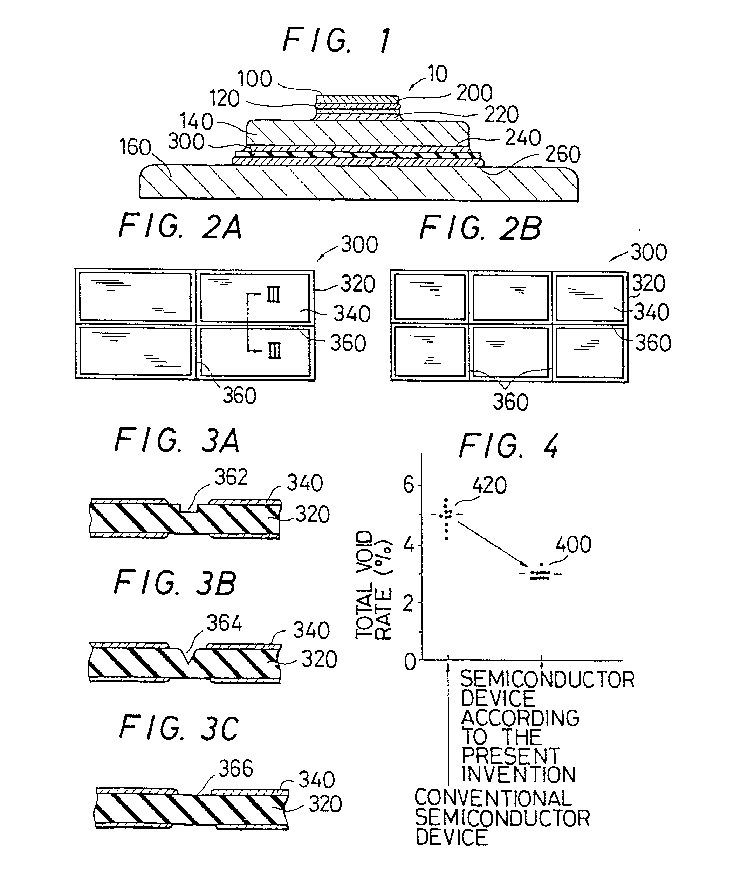

Referring initially to Figure 1, the semiconductor device 10 in accordance with the present invention includes a chip 100 of a transistor, especially of a power transistor, a molybdenum sheet 120 as a heat transfer mitigating member, a first heat sink 140 made of a highly heat-conductive metal such as copper, for example, a thermally conductive, electrically insulative plate 300 and a second heat sink 160 made of the same material as that of the first heat sink 140.

The power transistor chip 100 and the molybdenum sheet 120 are secured via a solder layer 200 while the molybdenum layer 120 and the first heat sink 140 are secured via a silver solder layer 220. The electrically insulative plate 300 is interposed and secured between the first and second heat sinks 140 and 160 via solder layers 240 and 260, respectively. In the semiconductor device 10 in accordance with the present invention, the first heat sink 140 may be removed so that the insulative plate 300 may be secured between the molybdenum sheet 120 and the second heat sink 160 via the solder layer.

As illustrated in Figure 2A, the insulative plate 300 comprises an insulative plate blank 320, metallized faces 340 formed on both sides of the blank 320 and slits 360 formed on one side or on both sides of the insulative plate blank 320. Though the insulative plate blank 320 in this embodiment consists of alumina, it may be made of beryllium. The metallized faces 340 are formed by the steps of first forming the slits 360, coating then tungsten onto both faces of the alumina blank and similtaneously baking both alumina and tungsten. Nickel plating is further applied to both faces in consideration of wettability with respect to a solder material.

The slits 360 are disposed in the longitudinal direction of the insulative plate blank 320 and in the directions falling/right angles thereto in the crisscross form before the metallized faces 340 are formed on the insulative plate blank 320. In this case, the number of slits in the longitudinal direction may be smaller than that of slits in the directions meeting at right angles to the longitudinal direction (see Figure 2B).

The heat transfer between the first heat sink 140 and the second heat sink 160 is effected via the metallized faces 340. If the number of slits is too great, therefore, the total area of the metallized faces 340 will decrease and hence, the heat transfer rate will also decrease. If the number of slits is too small, on the contrary, dissipation of the gas, which is taken into the solder layer at the time of soldering, is not sufficient so that voids are more easily formed and the heat transfer rate will decrease. Experiments have revealed that when the thickness of alumina is 1 mm, good heat transfer rate can be obtained by disposing the slits in the criss-cross arrangement so that each zone on the metallized face becomes 3mm - 4mm.

A preferred shape of the slit 360 to be formed on the insulative plate blank 320 has a notch having a U-shaped cross-sectional shape as shown in Figure 3A. Other preferred shapes of the slit are also shown in Figures 3B and 3C. The slit 362 shown in Figure 3A is formed by press-working the insulative plate blank 320 using a press or the like so as to form a notch having a ⊔ - or U-shaped cross-section. In this case, the metallized face 340 is formed at the portions other than the slit portion 362. The slit 364 shown in Figure 3B is formed in the same way so as to be provided with a notch having a V-shaped cross-section. Unlike the slits 362 and 364 shown respectively in Figures 3A and 3B,

0013314

the slit 366 shown in Figure 3C is constructed by a gap which is defined between divided metallized faces by forming the metallized faces 340 dividingly into plural units on the insulative plate blank 320.

Each of the slit structures shown in Figures 3A, 3B and 3C defines an escape passage of a gas which is entrapped in a solder layer when the insulative plate 300 is soldered to the heat sinks 140 and 160, and allows the gas to escape to the outside. Hence, occurrence of the voids due to the gas is reduced.

Each of the slit structures shown in Figures 3A and 3B has the notch on which thermal stress is apt to concentrate. Since the notches are not covered with the metallized faces 340, even when the insulative plate 300 is silver-soldered to the heat sinks 140 and 160 at a temperature of $800^\circ C.$, thermal contraction arising from the differences in the thermal expansion coefficients of the varying materials is apt to concentrate on the notches and is absorbed by them. Where the thermal contraction is so great as to exceed an allowable limit, the thermal contraction concentrates exclusively on the notches of the slits 362 and 364, thereby causing cracks, but electric insulation remains unaffected because the slit portions are not coated with the metallized faces. For this reason, it is possible to prevent dielectric breakdown due to high temperature soldering.

Figure 4 shows the comparison between the total void rate 400 (void-occurring area/area of insulative plate) of the semiconductor device 10 having the insulative plate 300 equipped with the slits 360 in accordance with the present invention and the total void rate 420 of the prior art semiconductor device having the conventional insulative plate. In Figure 4, the ordinate represents the total void rate (%) and the abscissa does the zones of the semiconductor device. As can be appreciated from Figure 4, the total void rate, which has conventionally been 5%, can be reduced down to 3%. This improves the reliability of the semiconductor device and eliminates the necessity of quality inspection of the semiconductor device by means of Roentgen inspection which has been indispensable conventionally.

In the foregoing explanation, both faces of the insulative plate 300 are secured to the heat sinks 140 and 160 by soldering. However, the present invention is not specifically limited to this embodiment so that one side may be secured by soldering while the other, by silver-soldering, for example. Furthermore, both sides may be secured by silver-soldering.

The metallized face/340 may be formed sufficiently only on the side to which soldering is to be applied. In the case of silver-soldering, it becomes unnecessary.

It is preferred that the slits 360 to be formed on the insulative plate /are disposed on the insulative plate on the side which is to be soldered. In the case of silver-soldering, the slits may be formed sufficiently on only one side, though silver-soldering is applied on both sides of the insulative plate.

Claims:

1. A semiconductor device comprising:
   a semiconductor wafer (100);
   a thermally conductive, electrically insulative member (300) secured to said semiconductor wafer (100) via a first securement layer (240) and having slits (360) formed on the faces thereof; and
   a thermally conductive heat sink (160) secured to said electrically insulative member (300) via a second securement layer (260).

2. The semiconductor device as defined in claim 1 wherein at least one slit (360) each is formed in the longitudinal direction of said electrically conductive member (300) and in a direction falling at right angles thereto on at least one face of said electrically conductive member (300).

3. The semiconductor device as defined in claim 1 or 2 wherein said slits (360) are so constructed at to be possessed of thermal stress concentration portions.

4. The semiconductor device as defined in claim 1 or 2 wherein said slits (360) are constructed by gaps (366) defined by forming dividingly a thermally conductive layer (340) covering said electrically insulative member (300).

5. The semiconductive device as defined in claim 1 or 2 wherein said electrically insulative member (300) is covered with a thermally conductive layer (340) at portions other than the portions of said slits (360).

0013314

6. A semiconductor device comprising:
a semiconductor wafer (100);
a heat transfer mitigating member (120) secured to said semiconductor wafer (100) via a first securement layer (200) and mitigating the heat transferred thereto from said semiconductor wafer (100);
a thermally conductive, electrically insulative member (300) secured to said heat transfer mitigating member (120) via a second securement layer (240) and having slits (360) formed on the faces thereof; and
a thermally conductive heat sink (160) secured to said electrically insulative member (300) via a third securement layer (260).

7. The semiconductor device as defined in claim 6 wherein at least one slit (360) each is formed in the longitudinal direction of said electrically insulative member (300) and in a direction falling at right angles thereto on at least one face of said electrically insulative member (300).

8. The semiconductor device as defined in claim 6 or 7 wherein said slits (360) are so constructed as to be possessed of thermal stress concentration portions.

9. The semiconductor device as defined in claim 6 or 7 wherein said slits (360) are constructed by gaps (366) defined by forming dividingly a thermally conductive layer (340) covering said electrically insulative member (300).

10. The semiconductor device as defined in claim 6 or 7 wherein said electrically insulative member (300) is covered with a thermally conductive layer (340) at portions other than the portions of said slits (360).

11. A semiconductor device comprising:

a semiconductor wafer (100);

a heat transfer mitigating member (120) secured to said semiconductor wafer (100) via a first securement layer (200) and mitigating the heat transferred thereto from said semiconductor wafer (100);

a first, thermally conductive heat sink (140) secured to said heat transfer mitigating member (120) via a second securement layer (220);

a thermally conductive, electrically insulative member (300) secured to said first heat sink (140) via a third securement layer (240) and having slits (360) formed on the faces thereof; and

a second, thermally conductive heat sink (160) secured to said electrically conductive member (300) via a fourth securement layer (260).

12. The semiconductor device as defined in claim 11 wherein at least one slit (360) each is formed in the longitudinal direction of said electrically insulative member (300) and in a direction falling at right angles thereto on at least one face of said electrically insulative member (300).

13. The semiconductive device as defined in claim 11 or 12 wherein said slits (360) are so constructed as to be possessed of thermal stress concentration portions.

14. The semiconductor device as defined in claim 11 or 12 wherein said slits (360) are constructed by gaps (366) defined by forming dividingly a thermally conductive layer (340) covering said electrically insulative member (300).

15. The semiconductor device as defined in claim 11 or 12 wherein said electrically insulative member (300) is covered with a thermally conductive layer (340) at portions other than the portions of said slits (360).

16. A semiconductor device comprising:

a power transistor chip (100);

a molybdenum sheet (120) secured to said power transistor chip (100) via a first solder layer (200) and mitigating the heat transferred thereto from said power transistor chip (100);

a first heat sink (140) made of copper and secured to said molybdenum sheet (120) via a silver solder layer (220);

a thermally conductive, electrically insulative plate (300) secured to said first heat sink (140) via a second solder layer (240);

said electrically insulative plate (300) consisting of an alumina plate, slits (362) of a U-shaped cross-section formed on both sides of said alumina plate (300) in its longitudinal direction and in the directions falling at right angles thereto, and thermally conductive, metallized faces (340) formed on both sides of said alumina plate (300) at portions other than the portions of said slits (362); and

a second heat sink (160) made of copper and secured to said electrically insulative plate (300) via a third solder layer (260).

0013314

1/1

FIG. 1

FIG. 2A

FIG. 2B

FIG. 3A

FIG. 3B

FIG. 3C

FIG. 4